Europäisches Patentamt

European Patent Office

Office européen des brevets

(11) Numéro de publication: **0 298 851 B1**

# FASCICULE DE BREVET EUROPEEN

(45) Date de publication de fascicule du brevet: **07.10.92**　(51) Int. Cl.⁵: **H01L 21/285**, H01L 21/90

(21) Numéro de dépôt: **88401720.3**

(22) Date de dépôt: **01.07.88**

(54) **Procédé de contact entre deux couches conductrices ou semiconductrices déposées sur un substrat.**

(30) Priorité: **03.07.87 FR 8709455**

(43) Date de publication de la demande:
**11.01.89 Bulletin 89/02**

(45) Mention de la délivrance du brevet:
**07.10.92 Bulletin 92/41**

(84) Etats contractants désignés:
**DE ES GB IT NL**

(56) Documents cités:
**EP-A- 0 201 250**
**US-A- 4 640 000**

**IEEE TRANSACTIONS ON ELECTRON DEVI-CES, vol. ED-29, no. 4, avril 1982, pages 596-600, IEEE, New York, US; T. NAKAMURA et al.: "Self-aligned transistor with sidewall base electrode"**

(73) Titulaire: **SGS-THOMSON MICROELECTRO-NICS S.A.**
**7, Avenue Galliéni**
**F-94250 Gentilly(FR)**

(72) Inventeur: **Bergemont, Albert**
**26 Chemin de Mausec**
**F-38700 La Tronche(FR)**
Inventeur: **Ferrant, Richard**
**Résidence Acropolis Bât. A Route de Nice**
**F-13100 Aix en Provence(FR)**

(74) Mandataire: **Ballot, Paul Denis Jacques et al**
**Cabinet Ballot-Schmit, 7, rue le Sueur**
**F-75116 Paris(FR)**

# Description

L'invention concerne un procédé de contact entre deux couches conductrices ou semiconductrices déposées sur un substrat. Ce procédé est utilisé principalement dans le domaine de la fabrication de circuits intégrés.

Dans l'art antérieur, les continuités électriques sont réalisées par des bandes de silicium polycristallin ou de métal déposées qui relient les zones dopées selon le schéma électrique désiré. Plus particulièrement, les continuités électriques sont réalisées en déposant sur le substrat correctement dopé ou sur un premier niveau de bandes en un matériau conducteur ou semiconducteur une couche d'un matériau isolant, en ouvrant des fenêtres dans cette couche puis en déposant et en gravant un second niveau de bandes en matériau conducteur ou semiconducteur. L'ouverture des fenêtres est obtenue en utilisant des procédés de photolithographie classique. Avec ces procédés, les contacts entre couches se réalisent physiquement sur leur surface, de telle sorte que pour une densité de courant faible, une surface importante soit réservée au contact.

L'invention procède d'une idée différente permettant une intégration plus poussée et une exploitation maximale des possibilités géométriques des règles de dessin dans un circuit intégré.

En conséquence, la présente invention a pour objet un procédé de contact entre deux couches conductrices ou semiconductrices déposées sur un substrat caractérisé par les étapes suivante:

- dépôt et gravure de la première couche conductrice ou semiconductrice,
- dépôt d'une couche isolante dans les conditions de pression et de température telles que la couche isolante soit amincie dans la région des flancs des zones gravées de la première couche par rapport à l'épaisseur sur la surface du substrat et sur les surfaces des zones gravées de la première couche,
- gravure chimique de la couche isolante sur une épaisseur au moins égale à l'épaisseur amincie mais nettement inférieure à l'épaisseur ailleurs,
- dépôt de la deuxième couche conductrice ou semiconductrice dans des conditions de pression et température aboutissant à un fort pouvoir couvrant,
- gravure de la deuxième couche conductrice ou semiconductrice de façon à maintenir au moins un contact sur le flanc de la première couche conductrice ou semiconductrice.

Selon un mode de réalisation préférentielle, la couche isolante est constituée par de l'oxyde de silicium contenant entre 8 et 9 % de phosphore. Ce dépôt est un dépôt en phase valeur à basse température et à faible pression.

Ce procédé présente de nombreux avantages. C'est un procédé beaucoup plus simple que les procédés photolithographiques utilisés habituellement car on n'utilise plus de masque. Il y a de plus autoalignement des contacts qui peuvent être réalisés sous de faibles dimensions.

Un autre avantage de l'invention est de permettre de programmer une jonction sans avoir à utiliser de masque. Cette caractéristique est extrêmement intéressante dans la réduction du nombre des opérations d'intégration. En particulier, l'invention s'applique à la fabrication de mémoires enregistrées permanentes dites à lecture seule ou mémoire ROM.

D'autres avantages et caractéristiques de la présente invention seront mieux compris à l'aide de la description faite ci-après avec référence aux dessins ci-annexés, dans lesquels:

- les figures 1 à 3 sont des vues en coupe représentant trois étapes du procédé selon l'invention,
- la figure 4 est une vue en perspective d'un mode de réalisation d'un circuit selon l'invention,
- la figure 5 est une vue schématique d'un autre mode de réalisation,
- la figure 6 est un schéma électrique d'un premier circuit réalisé selon l'invention,
- la figure 7 est un schéma électrique d'un second circuit réalisé selon l'invention,
- la figure 8 est un schéma de masquage du circuit de la figure 7,
- les figures 9 et 10 sont respectivement des vues en coupe par A - A et B - B de la figure 8.

Le brevet américain US-A-4 640 000 décrit un procédé selon lequel une couche isolante est déposée sur une structure semiconductrice. Des surélévations de cette couche isolante sont formées au-dessus des zones en relief de la structure semiconductrice. Lors d'une opération de gravure de la couche isolante, les flancs des surélévations sont attaqués de manière à dégager les bords des zones en relief et la partie contiguë du substrat.

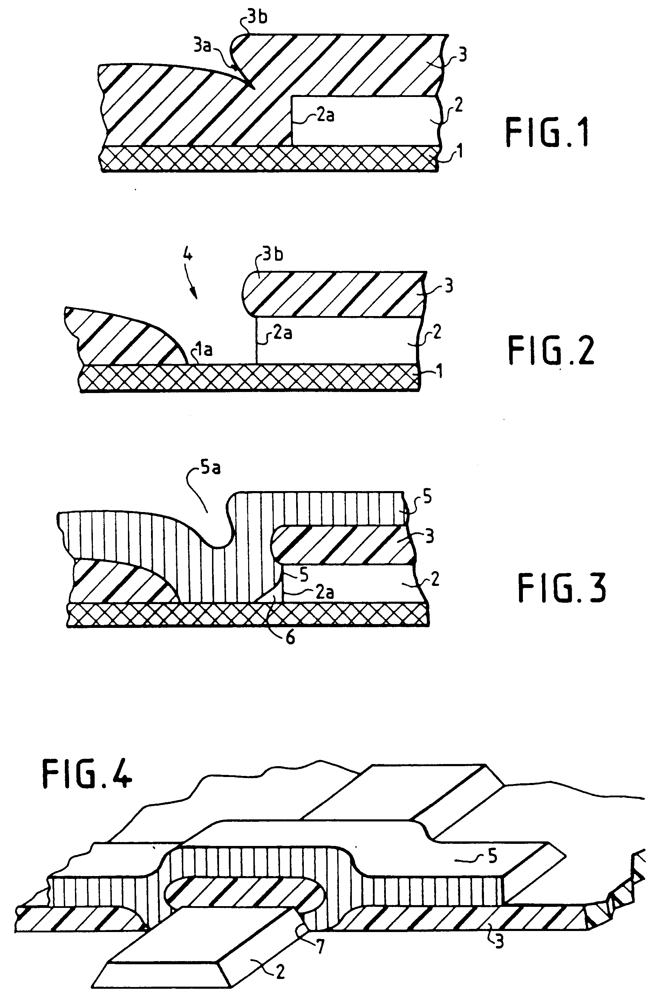

Sur les figures 1 à 3, on a représenté un procédé de réalisation de contacts entre deux couches semiconductrices. Sur la figure 1, on a représenté la première étape de fabrication. Une couche isolante 1 en oxyde de silicium, par exemple, sert de substrat. Une couche de silicium polycristallin est déposée puis gravée de manière à présenter une forme géométrique 2 en épaisseur sur le substrat 1. Cette forme présente au moins un flanc sensiblement vertical 2a qui est destiné à fournir une surface de contact pour une connexion ultérieure. Puis on dépose en phase vapeur à basse température une couche d'un matériau de transfert, à savoir une couche d'un matériau isolant, qui sert principalement à guider le silicium d'une seconde couche à croître au cours de son dépôt sur le flanc de contact 2a. Dans l'exemple de réalisation préférée, cette couche est un oxyde de silicium dopé au phosphore, déposé en phase vapeur à basse température et à faible pression. De préférence, l'oxyde de silicium contient entre 8 et 9 % de phosphore. Le dépôt est réalisé à une température comprise entre 400 et 450° C.

Dans ces conditions de dépôt, la couche de transfert est conformée de manière à créer un sillon 3a à la surélévation 3b de la couche au droit de la bande 2. Ce sillon 3a sera mis à profit au cours de l'étape suivante, illustrée à la figure 2.

Dans cette seconde étape, la couche de transfert 3 est gravée chimiquement. La géométrie du sillon 3a ainsi que les contraintes dans la couche 3a permettent une gravure préférentiellement autour de l'axe du sillon. Ainsi le substrat 1 est dégagé de l'oxyde de la couche de transfert 3 ainsi que le flanc 2a du silicium 2.

Sur la figure 3, on a représenté la constitution d'un contact sur le flanc 2a. On dépose une couche de silicium polycristallin sous des conditions convenables de pression et de température.

A partir du haut du flanc 2a, une zone de contact 5 s'établit. Un sillon 5a est apparent sur la surface libre de la couche 5. Ce sillon correspond à une poche vide 6 limitée par la couche 5, le substrat 1 et la couche 2. Cette poche 6 est d'autant plus réduite que la seconde couche 5 a un pouvoir couvrant important. Il est ainsi possible de contrôler les caractéristiques géométriques du contact entre les deux couches de silicium. Cette caractéristique de l'invention est mise à profit par élément pour la programmation de jonction P-N, chaque couche 2 ou 5 recevant un dopage P ou N.

Sur la figure 4, on a représenté une vue en perspective et en coupe partielle d'un morceau de circuit intégré où les éléments déjà décrits aux figures 1-3 gardent les mêmes chiffres de référence. La couche 2 de silicium polycristallin a été gravée en forme de bande et dopéede type P. La couche isolante en oxyde de silicium 3 a été dégagée moins largement qu'à lafigure 2. Ainsi la partie supérieure du flanc de la bande 2 est recouverte d'oxyde. En conséquence, la couche de silicium polycristallin 5, qui a été gravée à son tour sous forme de bande et dopée de type N, ne peut établir une zone de jonction que dans la zone 7 du flanc destinée à cet effet. De même, sur la partie cachée du dessin, une jonction PN est établie sur l'autre flanc disponible de la bande 2.

On voit que les connexions selon l'invention peuvent avoir de nombreuses formes géométriques avantageuses selon les applications auxquelles elles sont destinées.

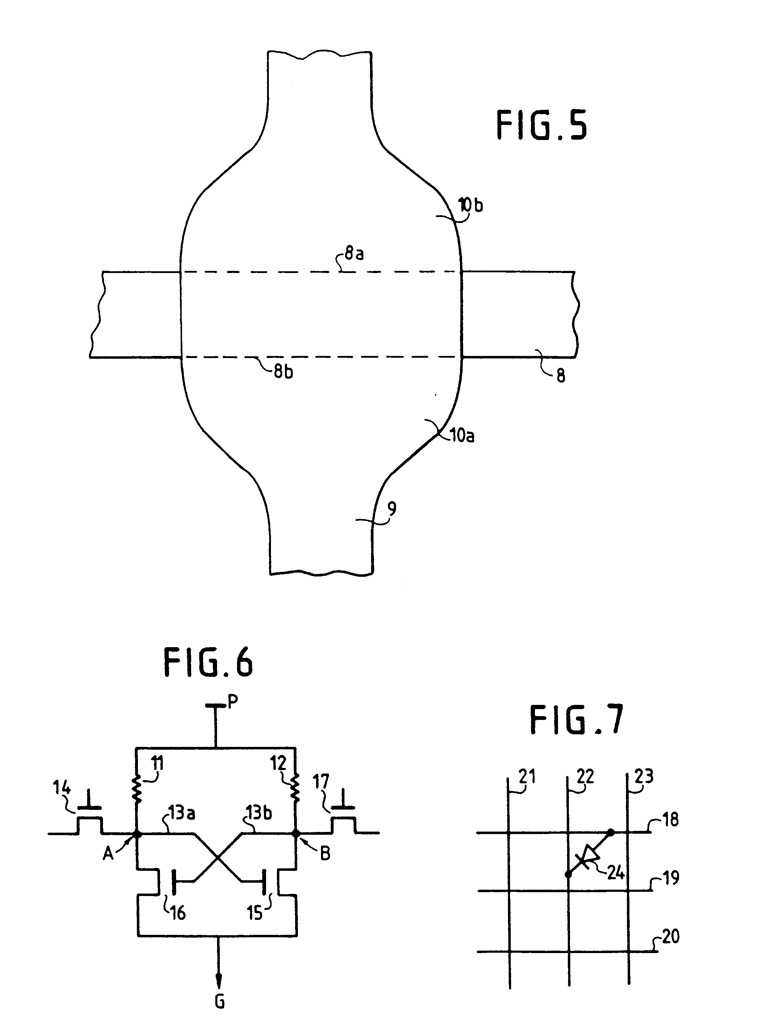

En particulier, pour des raisons de densité de courant, l'invention permet la réalisation de jonctions ou de connexions de surfaces importantes sur des encombrements relativement réduits. A la figure 5, on a représenté un mode de réalisation de cette caractéristique de l'invention. Une première bande 8, analogue à la bande 2 de la figure 4, a été gravée sur un substrat convenable. Une bande 9 a été déposée et gravée pour établir des jonctions avec les flancs 8a et 8b de la bande 8. Afin d'élargir la surface de jonction, la bande 9 est élargie dans la région 10 de transition où elle recouvre la bande inférieure 8 de manière à former les zones 10a et 10b.

Sur la figure 6, on a représenté une cellule de mémoire statique SRAM à quatre transistors, avec résistances de mise à "1" dites de "pull-up". Ces cellules sont crées à partir de deux bandes de silicium polycristallin selon le procédé décrit ci-dessus. Le premier niveau de silicium polycristallin suit les liaisons 13a puis 13b. De gauche à droite, la première bande relie la source puis le drain du transistor 14 et va rejoindre la zone de grille du transistor 15. Elle subit donc une première interruption entre source et drain du transistor 14 puis à l'arrivée à la grille du transistor 15. Elle se poursuit ensuite sur la grille du transistor 16 et va constituer le drain et la source du transistor 17.

La deuxième bande, ou deuxième niveau de silicium polycristallin, présente des zones de résistance 11 et 12 séparées par une connexion à la piste de polarisation P et dessine un chemin circulaire passant par les sources et drains des transistors 15 et 16. Elle comporte entre les drains des transistors 15 et 16, une connexion à la piste de mise à la masse G.

L'invention permet de résoudre simplement la question de la connexion des deux bandes de polysilicium 1 et 2 aux points communs A et B du schéma. A cet effet, on réalise des contacts biflancs comme décrits aux figures précédentes. Dans la technologie classique, ces deux contacts A et B présentent une surface non négligeable qui est, selon l'invention, considérablement réduite. D'autre part, l'invention permet, ici de supprimer le masque répétitif des connexions A/B intersilicium polycristallin de l'ensemble des cellules du plan mémoire SRAM.

Cette possibilité d'interconnexion entre deux niveaux de silicium polycristallin peut être étendue aux réseaux prédiffusés ainsi qu'aux réseaux programmés de type PLA.

Sur la figure 7, on a représenté une fraction d'une mémoire matricielle programmable de type ROM pour ready only memory, en langue anglaise. On peut y programmer un "1" ou un"0" logiques, par présence ou absence d'une jonction. A cet effet, les lignes 18-20 sont réalisées en un silicium polycristallin de type P gravé en bandes parallèles et les colonnes 21-23 en un silicium polycristallin de type N gravé en bandes parallèles orthogonales aux précédentes. Une seule jonction PN est programmée dans la zone représentée sur la figure 7.

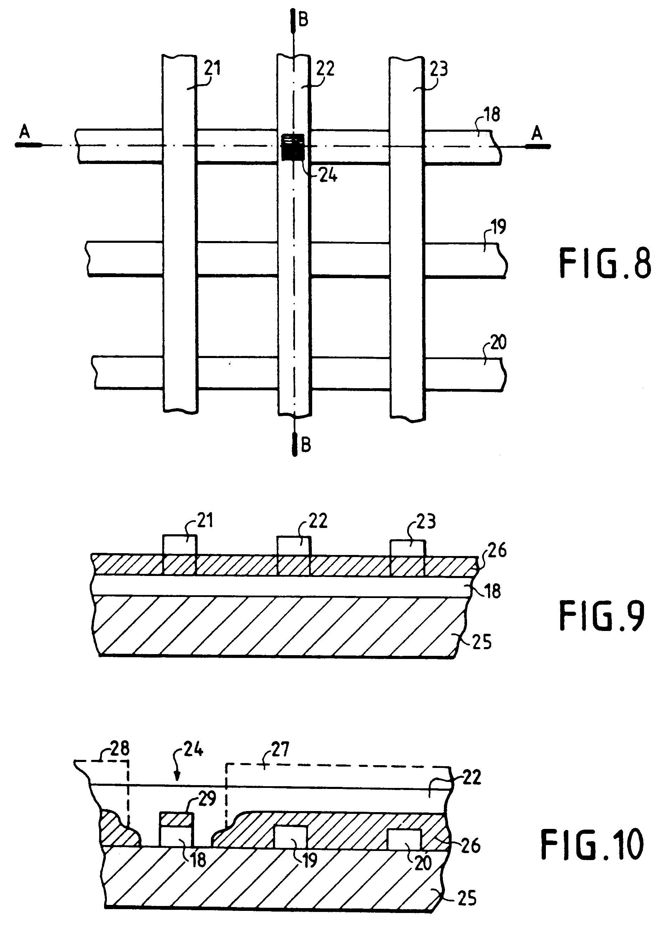

Sur les figures 8 à 10, on a représenté la réalisation de cette zone mémoire selon le procédé de la présente invention. Sur la figure 8, qui est une vue de dessus, on a représenté schématiquement la localisation de la jonction 24 à l'intersection des bandes 18 et 22. Le trait horizontal interrompu figure la coupe de la figure 9 et le trait vertical la coupe de la figure 10. Dans ces dessins, les mêmes éléments que ceux de la figure 7 sont désignés par les mêmes références.

La coupe de la figure 9 montre le substrat isolant 25, la ligne 18 en silicium polycristallin de type N et une couche isolante 26 en oxyde de silicium séparant les couches de silicium polycristallin. Cette couche peut être formée en bandes orthogonales superposées aux bandes de silicium polycristallin, mais elle peut aussi être gravée exclusivement aux places où une jonction est prévue. Dans le cas représenté sur la figure 8, la couche d'oxyde masquerait les lignes 18-20 et présenterait une ouverture entourant la zone de jonction 24. Par dessus cette couche ou bande 26, on remarque les bandes de silicium polycristallin de type P 21 à 23.

Sur la figure 10, les bandes de silicium polycristallin de type N 18-20 sont coupées. Seule la bande 18 reçoit un contact bi-flanc, protégé par un plot d'oxyde de silicium 29. Dans un mode de réalisation de l'invention, on a déposé par dessus l'oxyde 26, une couche de résine 27, 28 représentée en pointillés qui permet de protéger, en vue de la gravure, les zones d'oxyde à maintenir. Dans ce cas, la fenêtre ouverte dans la couche de résine n'a pas besoin d'être précise à l'inverse des procédés classiques.

L'invention permet en particulier de réduire de 10 à 20 % la surface totale occupée dans une cellule classique. Elle permet aussi d'éliminer une opération de masquage et en particulier, dans le cas de circuits à la demande, de repousser l'étape de programmation dans les circuits ROM, PLA, FPLP, ... en toute dernière phase du procédé de fabrication, ce qui permet de standardiser tout le début de la fabrication d'un produit donné.

**Revendications**

1. Procédé de contact entre deux couches conductrices ou semiconductrices déposées sur un substrat comportant les étapes successives suivantes :
   - dépôt et gravure de la première couche conductrice ou semiconductrice,
   - dépôt d'une couche isolante dans des conditions de pression et température telles que la couche isolante soit amincie dans la région des flancs des zones gravées de la première couche par rapport à l'épaisseur sur la surface du substrat et sur les surfaces des zones gravées de la première couche,
   - gravure chimique de la couche isolante sur une épaisseur au moins égale à l'épaisseur amincie mais nettement inférieure à l'épaisseur ailleurs,
   - dépôt de la deuxième couche conductrice ou semiconductrice dans des conditions de pression et température aboutissant à un fort pouvoir couvrant,
   - gravure de la deuxième couche conductrice ou semiconductrice de façon à maintenir au moins un contact sur le flanc de la première couche conductrice ou semiconductrice.

2. Procédé de contact selon la revendication 1, caractérisé en ce que la couche isolante est constituée par de l'oxyde de silicium contenant entre 8 et 9 % de phosphore.

3. Procédé de contact selon l'une quelconque des revendications 1 et 2, caractérisé en ce que le dépôt de la couche isolante est un dépôt en phase vapeur à basse température et à faible pression.

4. Procédé de contact selon la revendication 3, caractérisé en ce que le dépôt est réalisé à une température comprise entre 400 et 450°C.

5. Procédé de contact selon l'une quelconque des revendications 1 à 4, caractérisé en ce que les zones qui ne doivent pas être gravées, sont recouvertes d'une résine de protection.

**Claims**

1. A method for providing contact between two conductive or semiconductive layers deposited on a substrate comprising the following successive steps:
   - deposition and etching of the first conductive or semiconductive layer,
   - deposition of an insulating layer under pressure and temperature conditions such that the insulating layer is made thinner in the region of the side surfaces of the etched zones of the first layer relative to the thickness on the surface of the substrate and on the surfaces of the etched zones of the first layer,
   - chemical etching of the insulating layer to a depth at least equal to the thinned thickness but significantly less than the thickness elsewhere,
- deposition of the second conductive or semiconductive layer under pressure and temperature conditions leading to a high covering power,
- etching of the second conductive or semiconductive layer so as to maintain at least one contact on the side surface of the first conductive or semiconductive layer.

2. A method for providing contact as claimed in claim 1, characterized in that the insulating layer consists of silicon oxide containing between 8 and 9% phosphorus.

3. A method for providing contact as claimed in either one of claims 1 and 2, characterized in that the deposition of the insulating layer is performed by a vapour phase deposition at low temperature and at low pressure.

4. A method for providing contact as claimed in claim 3, characterized in that the deposition is performed at a temperature comprised between 400 and 450°C.

5. A method for providing contact as claimed in any one of claims 1 to 4, characterized in that the zones which do not have to be etched are covered with a protective resin.

**Patentansprüche**

1. Verfahren zum Kontaktieren von zwei auf einem Substrat abgeschiedenen leitenden oder halbleitenden Schichten, umfassend die nachstehenden aufeinanderfolgenden Schritte:
   - Ablagerung und Gravur der ersten leitenden oder halbleitenden Schicht,
   - Ablagerung einer Isolierschicht unter solchen Druck- und Temperaturbedingungen, daß die Isolierschicht im Bereich der Flanken der gravierten Zonen der ersten Schicht in bezug auf die Dicke über der Substratfläche und über der Fläche der gravierten Zone der ersten Schicht dünner gemacht wird,
   - chemische Gravur der Isolierschicht zumindest auf eine Dicke entsprechend der verdünnten Dicke, aber deutlich unterhalb der anderswo vorhandenen Dicke,
   - Ablagerung der zweiten leitenden oder halbleitenden Schicht unter Druck- und Temperaturbedingungen, die zu einer starken Abdeckung führen,
   - Gravur der zweiten leitenden oder halbleitenden Schicht, derart, daß man zumindest einen Kontakt an der Flanke der ersten leitenden oder halbleitenden Schicht erhält.

2. Verfahren zum Kontaktieren nach Anspruch 1, dadurch gekennzeichnet, daß die Isolierschicht gebildet ist aus Siliciumoxid, das zwischen 8 und 9% Phosphor enthält.

3. Verfahren zum Kontaktieren nach Anspruch 1 oder 2, dadurch gekennzeichnet, daß die Ablagerung der Isolierschicht in der Dampfphase bei niedriger Temperatur und bei geringem Druck erfolgt.

4. Verfahren zum Kontaktieren nach Anspruch 3, dadurch gekennzeichnet, daß die Ablagerung bei einer Temperatur zwischen 400 und 450°C durchgeführt wird.

5. Verfahren zum Kontaktieren nach einem der Ansprüche 1 bis 4, dadurch gekennzeichnet, daß die von der Gravur ausgesparten Zonen mit einem Schutzharz bedeckt werden.

FIG.1

FIG.2

FIG.3

FIG.4

**FIG.5**

**FIG.6**

**FIG.7**

FIG.8

FIG.9

FIG.10